# EUROPÄISCHE PATENTSCHRIFT

(11) **EP 3 339 798 B1**
(45) Veröffentlichungstag und Bekanntmachung des Hinweises auf die Patenterteilung: **23.09.2020**
(21) Anmeldenummer: 18157614.1
(22) Anmeldetag: 17.12.2014
(51) Int. Cl.: F42B 3/12

(54) **VERFAHREN ZUR HERSTELLUNG VON ELEKTRISCHEN AUSLÖSEELEMENTEN FÜR PYROTECHNISCHE GEGENSTÄNDE**
METHOD FOR PRODUCING ELECTRIC TRIGGER ELEMENTS FOR PYROTECHNIC ARTICLES
PROCÉDÉ DE FABRICATION D'ÉLÉMENTS DÉCLENCHEURS ÉLECTRIQUES POUR OBJETS PYROTECHNIQUES

(30) Priorität: 19.12.2013 DE 102013022323
(43) Veröffentlichungstag der Anmeldung: 27.06.2018
(62) Teilanmeldung aus: 14818948.3
(73) Patentinhaber: RUAG Ammotec GmbH, 90765 Fürth (DE)
(72) Erfinder: WINTER, Andreas, 90768 Fürth (DE); ULRICH, Georg, 90768 Fürth (DE)
(74) Vertreter: Schmid, Nils T.F.

(56) Entgegenhaltungen:
- WO-A1-02/057704
- DE-A1- 10 240 053
- US-A- 4 840 122

## Beschreibung

Die Erfindung betrifft ein Verfahren zur Herstellung von elektrischen Auslöseelementen für pyrotechnische Gegenstände wie Zünder oder Anzünder.

Ein solches Verfahren ist z.B. aus dem Stand der Technik DE 102 40 053 A1 bekannt.

Elektrische Auslöseelemente dienen dazu, einen Primärexplosivstoff als erstes Glied einer Zünd- oder Anzündkette zu initiieren. Dazu wird die entstehende Wärme genutzt, die ein stromdurchflossener Widerstand abgibt. Der Primärexplosivstoff befindet sich in direktem Kontakt zum elektrischen Widerstand und wird durch Erreichen seiner Verpuffungstemperatur initiiert. Der elektrische Widerstand kann z.B. in Form eines Drahtes ausgeführt sein.

Das Herstellungsverfahren bezieht sich auf eine spezielle Form von Anzündelementen bei denen der elektrische Widerstand durch einen dünnen Metallfilm auf einer isolierenden Substratfläche gebildet wird. Derartige Auslöselemente sind bereits seit vielen Jahren gebräuchlich. Die Widerstandsschicht aus einem Metall mit hohem spezifischem Widerstand wird dabei durch einen Physical Vapour Deposition-Prozess (PVD) auf das Substrat (z.B. Keramik oder Glas) aufgebracht und gegebenenfalls abseits der vorgesehenen wohldefinierten Widerstandsfläche durch eine weitere Schicht aus einem Material mit hoher elektrischer Leitfähigkeit verstärkt. Die Geometrie der Widerstandsfläche richtet sich nach den Anforderungen der Anwendung insbesondere in Bezug auf Widerstandswert und Initiierungscharakteristik (z.B. erforderliche Stromstärke). Bei gängigen Herstellungsverfahren wird die Form der Widerstandsfläche (deren Dicke durch die Schichtdicke des Metallfilm gegeben ist) durch Lasermaterialbearbeitung an jedem einzelnen Bauteil erzeugt.

Durch die Einwirkung der hohen Laserleistung während der Materialbearbeitung können an den Rändern des Laserschnitts unerwünschte Materialveränderungen auftreten. Diese Materialänderungen (sowohl geometrischer als auch substantieller Art) wirken sich negativ auf die Initiierungs-Charakteristiken der Widerstandsschicht aus. Außerdem ist die einzelne Bearbeitung jedes Auslöseelements sehr zeitaufwändig.

Die Erfindung hat sich die Aufgabe gestellt ein neues Verfahren zur Herstellung von Initialelemente basierend auf PVD-Schichten anzugeben, das eine saubere Ausgestaltung der Ränder der Widerstandsschichten zulässt. Außerdem war es wünschenswert, die Herstellkosten zu reduzieren.

Erfindungsgemäß wird die Aufgabe durch das Verfahren nach Anspruch 1 gelöst, bei dem zuerst photolithografisch ein Lack auf das Substrat aufgebracht wird. Dieser verhindert eine Beschichtung des Substrats in einem großflächigen Bereich, aber lässt einen in seiner Breite genau definierten Bereich der Substratoberfläche frei. Anschließend wird der PVD-Prozess auf Lack und Substrat durchgeführt. Dadurch wird eine elektrisch leitfähige Schicht zwischen den beiden Anschlusspolen des Auslöseelements hergestellt. Der Lack wird im Folgenden vom Substrat abgelöst, so dass man elektrisch nicht leitfähiges Substrat und einen in seiner Breite genau definierten Widerstandsbereich erhält, durch den später der Strom von einem Anschlusspol zum anderen fließen kann. Während des PVD-Prozesses wird die Dicke der Widerstandsschicht bereits eingestellt. Um die Länge ebenso genau zu erzeugen, wird erneut ein photolithografischer Prozess durchgeführt und ein genau definierter Bereich des Widerstandsstreifens mit Lack abgedeckt. Anschließend wird die gesamte Substratoberfläche mit einer relativ dicken Schicht gut leitfähigen Metalls überzogen (z.B. galvanische Vergoldung). Die Aufbringung des Metalls wird so gestaltet, dass in Bereichen die vom ersten Photolithographieprozess blankes Substrat aufweisen, kein Metall haftet. Anschließend wird der Lack vom zweiten Photolithografieprozess wieder abgelöst. Es bleibt ein durch den Photolack genau definierter Bereich übrig, der nur von der Schicht aus Metall mit hohem spezifischen Widerstand gebildet wird. Der erste Photolithografieprozess definiert die Breite der Widerstandsschicht und sorgt für Isolation in den umliegenden Gebieten, der zweite Prozess definiert die Länge und die zweite Schicht sorgt für gute elektrische Leitfähigkeit und gute Kontaktierung an den Anschlusspolen. Der PVD-Prozess selbst legt die Dicke der Widerstandsschicht fest. Zur genauen Einstellung des elektrischen Widerstands kann die PVD-Schicht ursprünglich zu dick ausgeführt werden und durch schrittweises Abtragen die Dicke verringert und damit der Widerstand genau eingestellt werden.
Falls keine Verstärkung der Kontaktflächen durch zusätzliche gut leitende Schichten erforderlich ist, kann die gesamte Widerstandsgeometrie mit einer geeigneten Fotomaske in einem einzigen Lithografieprozess realisiert werden.

Die besonderen Vorteile dieses Verfahrens liegen darin, dass sehr genau definierte Kanten des Widerstandsfilms entstehen und das Material über die gesamte Widerstandsfläche homogen ist (keine Materialveränderungen durch punktuelle Wärmeeinwirkung wie bei der Laserbearbeitung). Außerdem kann über Photomasken der Widerstand bei sehr vielen Auslöseelementen gleichzeitig aufgebracht werden und die Teile müssen im Fertigungsprozess erst zu einem späteren Zeitpunkt vereinzelt werden, was den Prozess schneller und kostengünstiger macht als herkömmliche Verfahren.

## Patentansprüche

1. Verfahren zur Herstellung von elektrischen Auslöseelementen für pyrotechnische Gegenstände, bei dem:
- in einem ersten photolithografischen Schritt ein Lack auf ein nicht elektrisch leitfähiges Substrat aufgebracht wird, um einen großflächigen Bereich des Substrats zu beschichten und einen in seiner Breite definierten Bereich der Substratoberfläche freizulassen;
- mittels eines PVD-Prozesses eine elektrisch leitfähige Schicht auf Lack und Substrat aufgebracht wird, um eine elektrisch leitfähige Schicht zwischen Anschlusspolen des Auslöseelements herzustellen;
- der Lack vom Substrat abgelöst wird, um einen in seiner Breite definierten Widerstandsbereich zu erhalten, durch den Strom fließen kann;
- in einem zweiten photolithografischen Schritt ein definierter Bereich der Widerstandsschicht mit Lack abgedeckt wird, um eine Länge der Widerstandsschicht zu definieren;
- die gesamte Substratoberfläche mit einer Schicht gut leitfähigen Metalls, wie eine galvanische Vergoldung, überzogen wird, wobei die Aufbringung des Metalls so gestaltet wird, dass in Bereichen, die vom ersten photolithografischen Schritt blankes Substrat aufweisen, kein Metall haftet;
- der in dem zweiten photolithografischen Schritt aufgebrachte Lack abgelöst wird, wobei ein durch den Lack definierter Bereich entsteht, der nur von der Schicht mit hohem spezifischen Widerstand gebildet wird;
wobei der erste photolithografische Schritt die Breite der Widerstandsschicht definiert und für eine Isolation in den umliegenden Gebieten sorgt, wobei der zweite photolithografische Schritt die Länge der Widerstandsschicht definiert und mittels des gut leitfähigen Metalls für die elektrische Leitfähigkeit und Kontaktierung an den Anschlusspolen sorgt.

2. Verfahren nach Anspruch 1, bei dem die Dicke der Widerstandschicht durch den PVD-Prozess festgelegt wird.

3. Verfahren nach Anspruch 1 oder 2, bei dem die mittels des PVD-Prozesses aufgebrachte elektrisch leitfähige Schicht schrittweise abgetragen wird, um die Dicke der Widerstandsschicht zu verringern und den Widerstand einzustellen.

## Claims

1. A method for producing electric trigger elements for pyrotechnic articles, **characterized in that**,
- in a first photolithographic stage a lacquer is applied to an electrically non-conductive substrate, to coat the substrate in a large region and leave a free a region of the substrate surface of defined width;
- an electrically conductive layer is applied by means of a PVD process on the lacquer and the substrate so that an electrically conductive layer between terminal poles of the trigger element is produced;
- the lacquer is released from the substrate so that an a resistor region of defined width is obtained, through which current can flow;
- in a second photolithographic stage a defined region of the resistor strip is covered with photoresist so that a defined length of the resistor region is defined;
- the entire substrate surface is covered with a layer of readily conductive metal, e.g. a galvanic gilding, wherein the application of the metal is configured so that in regions which have a bare substrate from the first photolithographic process, no metal adheres;
- the lacquer from the second photolithographic process is removed, wherein a defined region defined by the lacquer remains, which is formed only by the layer of metal with a high specific resistance;
- wherein first photolithographic process defines the width of the resistor layer and provides for insulation in the surrounding regions, wherein the second photolithographic process defines the length and provides for good electrical conductivity and good contact at the terminal poles.

2. The method as claimed in claim 1, **characterized in that** the thickness of the resistor layer is determined by the PVD process.

3. The method as claimed in claim 1 or 2, **characterized in that** the conductive layer and step-wise removed so that the thickness of the resistor region is reduced and to set the resistance.

## Revendications

1. Procédé, destiné à fabriquer des éléments déclencheurs électriques pour des objets pyrotechniques lors duquel :
- dans une première étape photo-lithographique, on applique un vernis sur un substrat non conducteur d'électricité, pour revêtir une zone à grande surface du substrat et pour laisser libre une zone de largeur définie de la surface du substrat ;
- au moyen d'un processus PVD, on applique une couche conductrice d'électricité sur le vernis et le substrat, pour créer une couche conductrice d'électricité entre des pôles de connexion de l'élément déclencheur ;
- on retire le vernis du substrat, pour obtenir une zone de résistance de largeur définie à travers lequel peut circuler du courant ;
- dans une deuxième étape photo-lithographique, on recouvre de vernis une zone définie de la couche de résistance, pour définir une longueur de la couche de résistance ;
- on enrobe toute la surface du substrat d'une couche d'un métal bon conducteur, tel qu'une dorure galvanique, l'enrobage de métal étant conçu de telle sorte qu'aucun métal n'adhère dans des zones qui du fait de la première étape photo-lithographique comporte du substrat à nu ;
- on retire le vernis appliqué dans la deuxième étape photo-lithographique, en donnant naissance à une zone définie par le vernis qui n'est couverte que par la couche de haute résistance spécifique ;
la première étape photo-lithographique définissant la largeur de la couche de résistance et assurant une isolation dans des zones environnantes, la deuxième étape photo-lithographique définissant la longueur de la couche de résistance et au moyen d'un métal bon conducteur, assurant la bonne conductibilité électrique et la mise en contact sur les pôles de connexion.

2. Procédé selon la revendication 1, lors duquel on détermine l'épaisseur de la couche de résistance par un processus PVD.

3. Procédé selon la revendication 1 ou 2, lors duquel on retire progressivement en partie la couche conductrice d'électricité appliquée au moyen du processus PVD, pour réduire l'épaisseur de la couche de résistance et pour régler la résistance.
